# EUROPEAN PATENT SPECIFICATION

(11) **EP 2 449 576 B1**
(45) Date of publication and mention of the grant of the patent: **25.01.2017**
(21) Application number: 09736883.1
(22) Date of filing: 02.10.2009
(51) Int. Cl.: H01L 21/67, G03F 7/20

(54) **SUBSTRATE PROCESSING SYSTEM**
SUBSTRATVERARBEITUNGSSYSTEM
SYSTÈME DE TRAITEMENT DE SUBSTRAT

(30) Priority: 03.07.2009 IT UD20090129
(43) Date of publication of application: 09.05.2012
(73) Proprietor: Applied Materials, Inc., Santa Clara, CA 95054 (US)
(72) Inventor: BACCINI, Andrea, 31030 Mignagola di Carbonera (IT); GALIAZZO, Marco, 35127 Padova (IT); VERCESI, Tommaso, 31057 Silea (TV) (IT)
(74) Representative: Zimmermann & Partner Patentanwälte mbB
(86) International application number: PCT/EP2009/062845
(87) International publication number: WO 2011/000442

(56) References cited:
- EP-A- 1 111 471
- EP-A- 1 582 932
- EP-A- 1 655 765
- EP-A- 1 713 113
- EP-A- 2 066 010
- WO-A-98/28665
- JP-A- 2009 049 377
- JP-A- 2009 053 703
- US-A- 5 973 459
- US-A1- 2003 111 912
- US-A1- 2004 231 146
- US-A1- 2007 247 607
- US-A1- 2009 020 392

## Description

### BACKGROUND OF THE INVENTION

### Field of the Invention

Embodiments of the present invention generally relate to an apparatus and method for moving, aligning, and processing a substrate. In particular, embodiments of the present invention may be used to accurately deposit a patterned layer on a substrate.

### Description of the Related Art

Solar cells are photovoltaic (PV) devices that convert sunlight directly into electrical power. Solar cells typically have one or more p-n junctions. Each p-n junction comprises two different regions within a semiconductor material where one side is denoted as the p-type region and the other as the n-type region. When the p-n junction of a solar cell is exposed to sunlight (consisting of energy from photons), the sunlight is directly converted to electricity through the PV effect. Solar cells generate a specific amount of electric power and are tiled into modules sized to deliver the desired amount of system power. Solar modules are joined into panels with specific frames and connectors. Solar cells are commonly formed on silicon substrates, which may be single or multicrystalline silicon substrates. A typical solar cell includes a silicon wafer, substrate, or sheet typically less than about 0.3 mm thick with a thin layer of n-type silicon on top of a p-type region formed on the substrate.

The PV market has experienced growth at annual rates exceeding 30% for the last ten years. Some articles suggest that solar cell power production world-wide may exceed 10 GWp in the near future. It is estimated that more than 95% of all solar modules are silicon wafer based. The high market growth rate in combination with the need to substantially reduce solar electricity costs has resulted in a number of serious challenges for inexpensively forming high quality solar cells. Therefore, one major component in making commercially viable solar cells lies in reducing the manufacturing costs required to form solar cells by improving device yield and increasing substrate throughput in a solar cell fabrication process.

Screen and ink jet printing have been used in printing designs on objects, such as cloth or ceramics, and are used in the electronics industry for printing electrical component patterns, such as electrical contacts or interconnects on a surface of a substrate. State of the art solar cell fabrication processes also use screen and ink jet printing processes. In these processes, the production throughput is limited by the amount of time used in moving and printing a pattern on a single substrate. One method of increasing throughput is by printing a pattern on more than one substrate at a time via a single print head. However, current methods fail to provide consistent pattern alignment on each individual substrate, which can lead to poor device performance and low device efficiency.

EP 1713113A is situated in the field of scanning stepper technology and describes an exposure apparatus equipped with an illumination system, a projection unit, a wafer stage unit and alignment systems. The projection unit includes a projection optical system consisting of a plurality of optical elements. The alignment systems are used for measuring the position of alignment marks. A left-hand side loading position and a right-hand side loading position are described.

Therefore, there is a need for an apparatus for the production of solar cells, electronic circuits, or other useful devices that has an improved method of controlling the movement and alignment of substrates within a substrate processing system.

### SUMMARY OF THE INVENTION

According to an embodiment, an apparatus for processing a substrate according to independent claim 1 is provided.

According to a further embodiment, an apparatus for processing a substrate according to independent claim 6 is provided.

According to a yet further embodiment, a method for processing a substrate according to independent claim 13 is provided.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1 is a schematic isometric view of a processing system according to one embodiment of the present invention.
Figure 2 is a schematic plan view of the system depicted in Figure 1.
Figure 3 is a schematic plan view of the system depicted in Figure 1 illustrating alternate service aspects of the system.
Figure 4 is a schematic isometric view of an actuator assembly according to one embodiment of the present invention.
Figures 5A and 5B are schematic isometric views of a processing nest according to alternate embodiments of the present invention.
Figure 6 is a schematic diagram of an operational sequence according to embodiments of the present invention.
Figures 7A-7D are schematic plan views of the system illustrating the operational sequence of Figure 6 according to embodiments of the present invention.
Figures 8A and 8B are partial, plan views of the system illustrating an alignment sequence according to one embodiment of the present invention.
Figure 9A is a plan view depicting a single processing head having four processing nests, each supporting a substrate, positioned thereunder for a processing operation according to one embodiment of the present invention.
Figure 9B is a plan view depicting a single processing head having two processing nests, each supporting a substrate, positioned thereunder for a processing operation according to one embodiment of the present invention.

### DETAILED DESCRIPTION

Embodiments of the present invention provide an apparatus and method for processing substrates in a processing system that has an increased system throughput, improved system uptime, and improved device yield performance, while maintaining a repeatable and accurate substrate processing. In one embodiment, the processing system is adapted to perform a screen or ink jet printing process within a portion of a crystalline silicon solar cell production line in which a substrate is patterned with a desired material, and is then processed in one or more subsequent processing chambers. The subsequent processing chambers may be adapted to perform one or more bake steps and one or more cleaning steps. In one embodiment, the system is a module positioned within the Softline^{™} tool available from Baccini S.p.A., which is owned by Applied Materials, Inc. of Santa Clara, California. In another embodiment, the processing system is adapted to perform material removal processes, such as laser ablation or etching one or more regions of a substrate. In other embodiments, the processing system may be adapted to perform other material removal, deposition, thermal, and/or device testing processes.

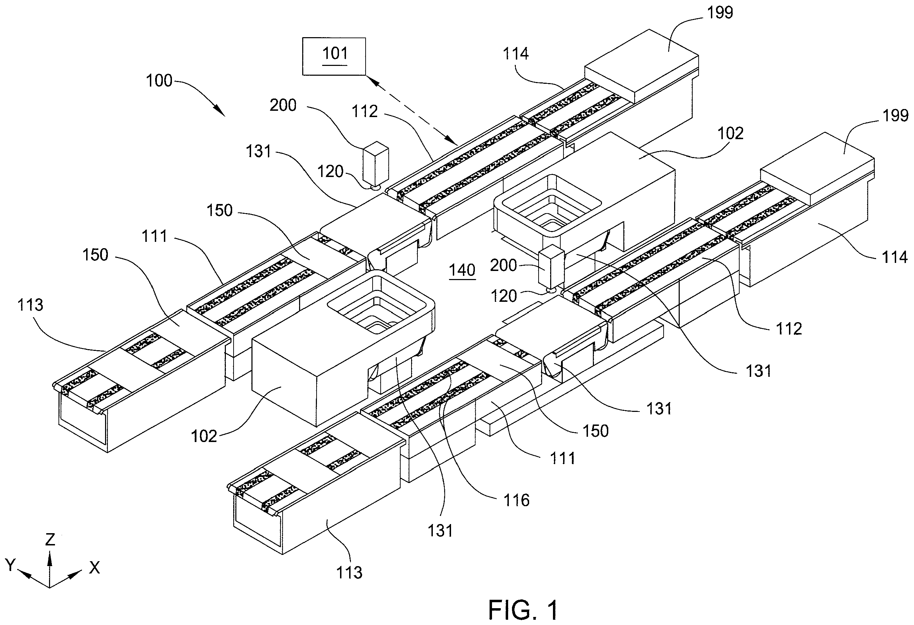

Figure 1 is a schematic isometric view of a substrate processing system, or system 100, according to one embodiment of the present invention. In one embodiment, the system 100 generally includes two incoming conveyors 111, an actuator assembly 140, a plurality of processing nests 131, a plurality of processing heads 102, two outgoing conveyors 112, and a system controller 101. The incoming conveyors 111 are configured in a parallel processing configuration so that each can receive unprocessed substrates 150 from an input device, such as an input conveyor 113, and transfer each unprocessed substrate 150 to a processing nest 131 coupled to the actuator assembly 140. Additionally, the outgoing conveyors 112 are configured in parallel so that each can receive a processed substrate 150 from a processing nest 131 and transfer each processed substrate 150 to a substrate removal device, such as an exit conveyor 114. In one embodiment, the input conveyor 113 and the exit conveyor 114 are automated substrate handling devices that are part of a larger production line, for example the Softline^{™} tool that is connected to the system 100. In one embodiment, each exit conveyor 114 is adapted to transport processed substrates 150 through an oven 199 to cure material deposited on the substrate 150 via the processing heads 102.

In one embodiment, substrates 150 are microcrystalline silicon substrates used for processing solar cells thereon. In another embodiment, substrates 150 are green tape ceramic substrates or the like.

In one embodiment of the present invention, the system 100 is a screen printing processing system and the processing heads 102 include screen printing components, which are configured to screen print a patterned layer of material on a substrate 150. In another embodiment, the system 100 is an ink jet printing system and the processing heads 102 include ink jet printing components, which are configured to deposit a patterned layer of material on a substrate 150. In yet another embodiment, the system 100 is a processing system that includes material removal components in the processing head 102, such as a laser for ablating or etching one or more regions of a substrate 150. In other embodiments, the system 100 may comprise other substrate processing modules requiring precise movement and positioning of the substrates for processing.

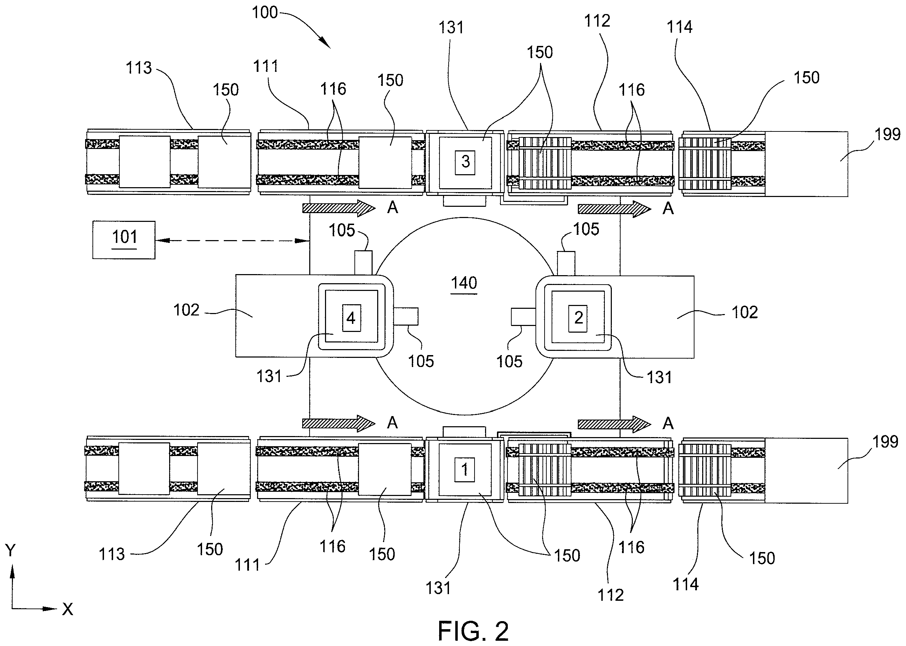

Figure 2 is a schematic plan view of the system 100 depicted in Figure 1. Figures 1 and 2 illustrate the system 100 having two processing nests 131 (in positions "1" and "3") each positioned to both transfer a processed substrate 150 to the outgoing conveyor 112 and receive an unprocessed substrate 150 from the incoming conveyor 111. Thus, in the system 100, the substrate motion generally follows the path "A" shown in Figures 1 and 2. In this configuration, the other two processing nests 131 (in positions "2" and "4") are each positioned under a processing head 102 so that a process (*e.g*., screen printing, ink jet printing, material removal) can be performed on the unprocessed substrates 150 situated on the respective processing nests 131. Such a parallel processing configuration allows increased processing capacity with a minimized processing system footprint. Although, the system 100 is depicted having two processing heads 102 and four processing nests 131, the system 100 may comprise additional processing heads 102 and/or processing nests 131 without departing from the scope of the present invention.

In one embodiment, the incoming conveyor 111 and outgoing conveyor 112 include at least one belt 116 to support and transport the substrates 150 to a desired position within the system 100 by use of an actuator (not shown) that is in communication with the system controller 101. While Figures 1 and 2 generally illustrate a two belt style substrate transferring system, other types of transferring mechanisms may be used to perform the same substrate transferring and positioning functions without varying from the basic scope of the invention.

In one embodiment, the system 100 also includes an inspection system 200, which is adapted to locate and inspect the substrates 150 before and after processing has been performed. The inspection system 200 may include one or more cameras 120 that are positioned to inspect a substrate 150 positioned in the loading/unloading positions "1" and "3," as shown in Figures 1 and 2. The inspection system 200 generally includes at least one camera 120 *(e.g.,* CCD camera) and other electronic components that are able to locate, inspect, and communicate the results to the system controller 101. In one embodiment, the inspection system 200 locates the position of certain features of an incoming substrate 150 and communicates the inspection results to the system controller 101 for analysis of the orientation and position of the substrate 150 to assist in the precise positioning of the substrate 150 under a processing head 102 prior to processing the substrate 150. In one embodiment, the inspection system 200 inspects the substrates 150 so that damaged or mis-processed substrates can be removed from the production line. In one embodiment, the processing nests 131 may each contain a lamp, or other similar optical radiation device, to illuminate the substrate 150 positioned thereon so that it can be more easily inspected by the inspection system 200.

The system controller 101 facilitates the control and automation of the overall system 100 and may include a central processing unit (CPU) (not shown), memory (not shown), and support circuits (or I/O) (not shown). The CPU may be one of any form of computer processors that are used in industrial settings for controlling various chamber processes and hardware (*e*.*g*., conveyors, detectors, motors, fluid delivery hardware, etc.) and monitor the system and chamber processes (*e*.*g*., substrate position, process time, detector signal, etc.). The memory is connected to the CPU, and may be one or more of a readily available memory, such as random access memory (RAM), read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the system controller 101 determines which tasks are performable on a substrate. Preferably, the program is software readable by the system controller 101, which includes code to generate and store at least substrate positional information, the sequence of movement of the various controlled components, substrate inspection system information, and any combination thereof.

In one embodiment, the two processing heads 102 utilized in the system 100 may be conventional screen printing heads available from Baccini S.p.A. which are adapted to deposit material in a desired pattern on the surface of a substrate 150 disposed on a processing nest 131 in position "2" or "4" during a screen printing process. In one embodiment, the processing head 102 includes a plurality of actuators, for example, actuators 105 (e.g., stepper motors or servomotors) that are in communication with the system controller 101 and are used to adjust the position and/or angular orientation of a screen printing mask (not shown) disposed within the processing head 102 with respect to the substrate 150 being printed. In one embodiment, the screen printing mask is a metal sheet or plate with a plurality of holes, slots, or other apertures formed therethrough to define a pattern and placement of screen printed material on a surface of a substrate 150. In one embodiment, the screen printed material may comprise a conductive ink or paste, a dielectric ink or paste, a dopant gel, an etch gel, one or more mask materials, or other conductive or dielectric materials. In general, the screen printed pattern that is to be deposited on the surface of a substrate 150 is aligned to the substrate 150 in an automated fashion by orienting the screen printing mask using the actuators 105 and information received by the system controller 101 from the inspection system 200. In one embodiment, the processing heads 102 are adapted to deposit a metal containing or dielectric containing material on a solar cell substrate having a width between about 125 mm and 156 mm and a length between about 70 mm and 156 mm.

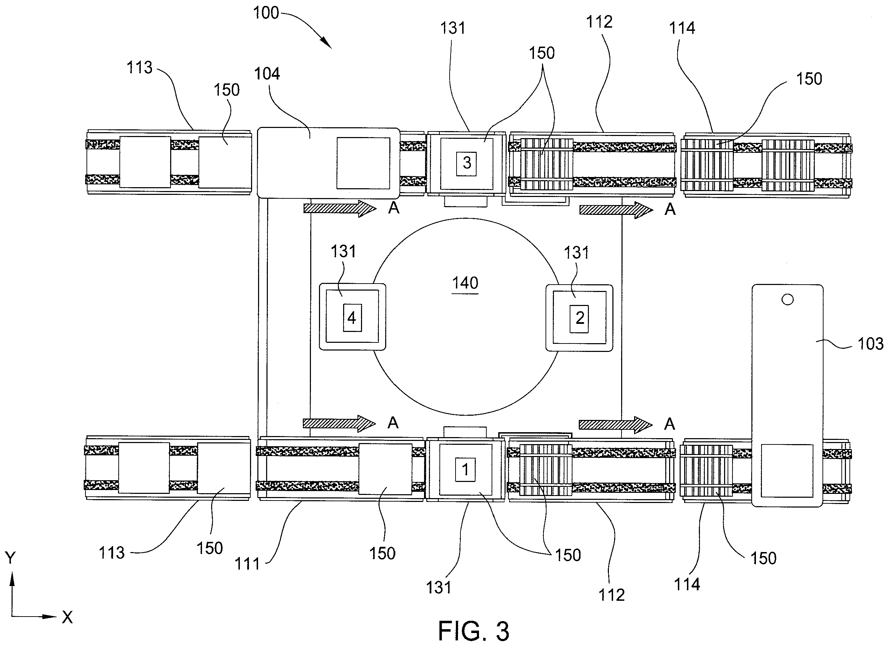

Figure 3 is a schematic plan view of the system 100 depicted in Figure 2 illustrating alternate service aspects of the processing heads 102 according to embodiments of the present invention. In one embodiment, a portion of each processing head 102 may be linearly movable over one of the incoming conveyors 111 or outgoing conveyors 112 as depicted by the processing head 103. In another embodiment, a portion of each processing head 102 may be angularly movable (*e*.*g*. swiveled about a pivot) over one of the incoming conveyors 111 or output conveyors 112 as depicted by the processing head 104. In either configuration, the movement of the portion of the respective processing head 102 to one side or the other allows one of the processing heads 102 and a corresponding incoming conveyor 111 or outgoing conveyor 112 to be taken down for service while the incoming conveyor 111 and corresponding outgoing conveyor 112 positioned on the other side continues production in conjunction with the opposite processing head 102.

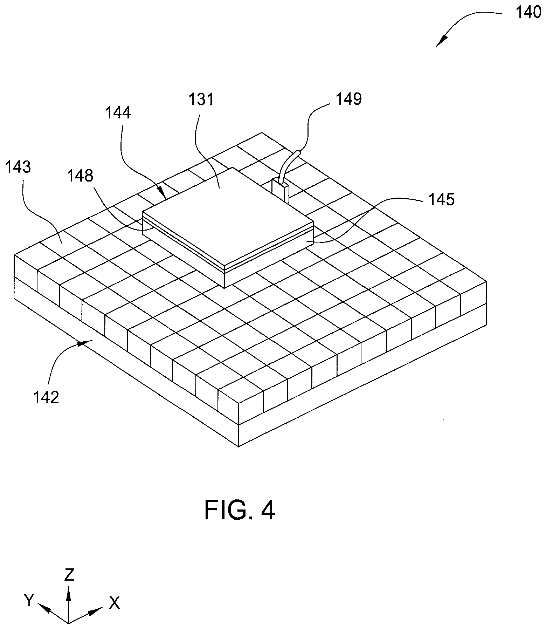

Figure 4 is a schematic isometric view of an actuator assembly 140 according to one embodiment of the present invention. In one embodiment, the actuator assembly 140 is a planar motor comprising a stator 142 and one or more movers 144. The stator 142 may include a permanent magnet part 143 having a plurality of S-pole permanent magnets and N-pole permanent magnets arranged in a grid form. The mover 144 may include an armature coil part 145, which receives an electric signal via cables 149. When an electric signal is applied to the armature coil part 145, a thrust is generated between the armature coil part 145 of the mover 144 and the permanent magnet part 143 of the stator 142.

In order to transfer the mover 144 in the X-Y direction on the plane of the stator 142 by virtue of the thrust generated between the permanent magnet part 143 and the armature coil part 145, the mover 144 may be raised a predetermined height from the plane surface of the stator 142 via one or more air nozzles (not shown) provided in the lower surface of the mover 144. Thus, when the mover 144 receives an electric signal via the cables 149, air may also be delivered through the nozzles via tubing coupled to an air source and disposed in the cables 149. The delivery of air through the nozzles allows near frictionless X-Y movement and precise X-Y positioning of the mover 144 on the stator 142.

In one embodiment of the present invention, each mover 144 has a respective processing nest 131 coupled thereto. In such an embodiment, the actuator assembly 140 is capable of precise X-Y movement and positioning of each processing nest 131 via signals sent through cables 149 from the system controller 101. In one embodiment, the actuator assembly 140 allows significant improvement in accuracy and repeatability over prior art substrate processing positioning systems.

In one embodiment, each of the processing nests 131 is affixed to a rotary actuator 148, which is positioned between and coupled to the processing nest 131 and its respective mover 144. The rotary actuator 148 may include a rotary plate attached to a stepper motor, servo motor, or other rotary mechanism in communication with the system controller 101 for precisely positioning each of the processing nests 131 at an angle with respect to the respective mover 144.

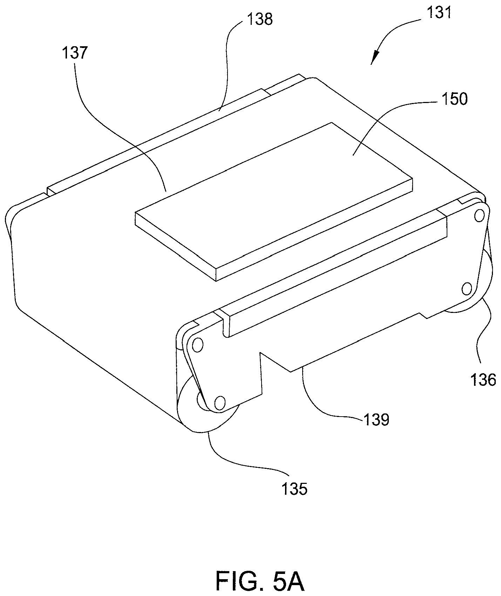

Figures 5A-5B are schematic isometric views of one of the processing nests 131 according to alternate embodiments of the present invention. In one embodiment, each processing nest 131 comprises a conveyor 139 that has a feed spool 135 and a take-up spool 136 that are adapted to feed and retain a material 137 positioned across a platen 138 as shown in Figure 5A. In one embodiment, the material 137 is a porous material that allows a substrate 150 disposed on one side of the material 137 to be held to the platen 138 by a vacuum applied to the opposing side of the material 137 by vacuum ports formed in the platen 138. In one embodiment, a vacuum is supplied to the platen 138 by use of a vacuum source (not shown) coupled to the ports in the platen 138 using tubing (not shown) disposed in the bundle of cables 149.

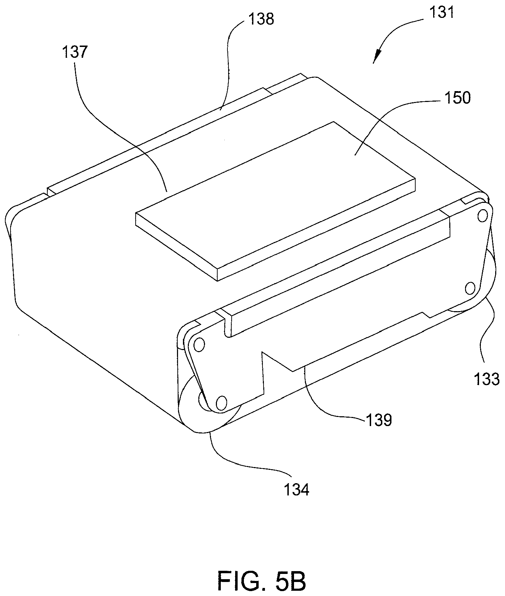

In another embodiment, the conveyor 139 is configured as a continuous conveyor system comprising one or more feed rollers 133 and one or more idler rollers 134 for feeding the material 137 positioned across the platen 138 as shown in Figure 5B. The platen 138 may have a substrate supporting surface on which the substrate 150 and material 137 are supported and retained during the processing performed in the processing head 102. In one embodiment, the material 137 is a porous material that allows a substrate 150 disposed on one side of the material 137 to be held to the platen 138 by a vacuum applied to the opposing side of the material 137 by vacuum ports formed in the platen 138. In one embodiment, a vacuum is supplied to the platen 138 by use of a vacuum source (not shown) coupled to the ports in the platen 138 using tubing (not shown) disposed in the bundle of cables 149. In one embodiment, the material 137 is cleaned as it is fed by the feed rollers 133 after transferring the substrate 150.

In certain embodiments of the present invention, the processing nests 131 are always configured in the same orientation when loading and unloading substrates 150. In such embodiments, the continuous conveyor configuration (Figure 5B) may be preferred over the former conveyor configuration (Figure 5A) since the former configuration consumes the material 137 as each substrate 150 is loaded and unloaded from the processing nest 131. Thus, in the conveyor configuration in Figure 5A, the material 137 must be periodically removed and replaced during processing. In contrast, the continuous conveyor configuration (Figure 5B) does not consume the material 137 during loading and unloading of each substrate 150. Therefore, the continuous conveyor system, as shown in Figure 5B, may provide cycle time, throughput, and yield benefits in certain embodiments of the present invention.

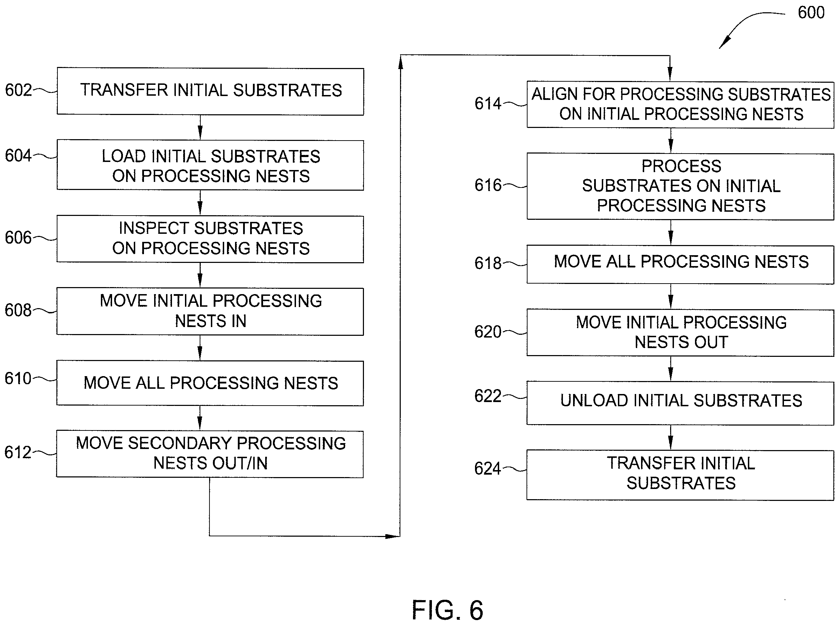

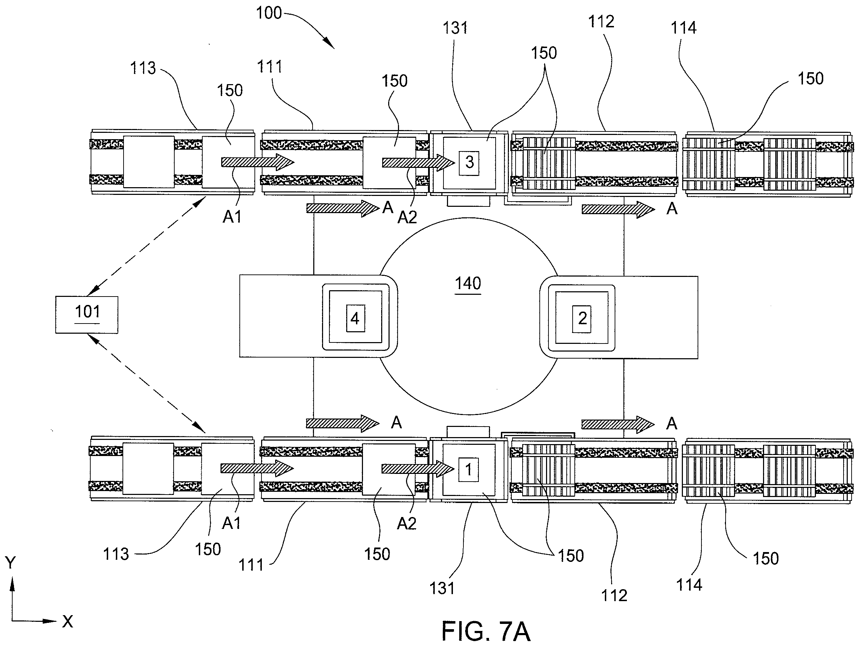

Figure 6 is a schematic diagram of an operational sequence 600 according to embodiments of the present invention. Figures 7A-7D are schematic plan views of the system 100 illustrating the operational sequence 600 according to embodiments of the present invention.

In a substrate transferring operation 602, a first pair of substrates 150 is transferred along the paths "A1" from the input conveyors 113 to the incoming conveyors 111. In this configuration the system controller 101 is used to coordinate the motion of the belts 116 and drive actuators (not shown) in each input conveyor 113 and incoming conveyor 111 so that the substrates 150 are reliably transferred between these automated components.

Next, in a substrate loading operation 604, each of the incoming conveyors 111 load the first pair of substrates 150 onto the processing nests 131 located in loading/unloading positions "1" and "3" as shown in Figure 7A. In this configuration, each substrate 150 is transferred from the belts 116 of the incoming conveyors 111 to the material 137 of the conveyor 139 in the processing nest 131 following the transfer path "A2." At this point, it is important to note that in steady state operation, the processing nests 131 in the loading/unloading positions "1" and "3" support a processed substrate 150 that is simultaneously unloaded as the respective processing nest 131 is being loaded with the unprocessed substrate 150. In this configuration the system controller 101 is used to coordinate the motion of the belts 116 and the feed rollers 133 (Figure 5B) or feed spool 135 and take-up spool 136 (Figure 5A) for reliably positioning the substrates 150 on the processing nests 131.

In an inspection operation 606, each of the first pair of substrates 150 may be inspected by the inspection system 200 to assure that there are no broken, chipped, or cracked substrates 150 positioned on the processing nests 131. Additionally, each inspection system 200 may capture images of the substrate 150 positioned on the processing nest 131 and send the images to the system controller 101 for analysis to determine the exact position and orientation of each substrate 150 on the respective processing nest 131. The location and orientation data of each substrate 150 on each processing nest 131 is subsequently used by the system controller 101 in conjunction with the respective processing head 102 and/or mover 144 for precise positioning of the substrate 150 during a processing operation as subsequently described.

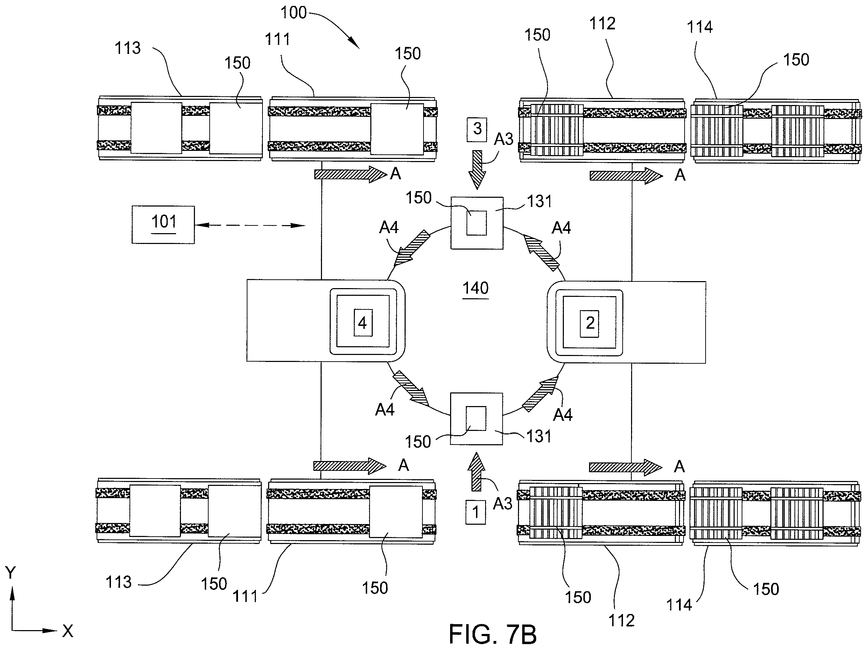

Next, in a first processing nest moving operation 608, the processing nests 131 with the unprocessed substrates 150 disposed thereon are each moved inwardly from their respective loading positions "1" and "3" along path "A3" as shown in Figure 7B. In this configuration, only the printing nests 131 originally positioned in the loading/unloading positions "1" and "3" are moved via their respective movers 144. The system controller 101 is used to coordinate the movement of the movers 144 of the actuator assembly 140 to assure that the processing nests 131 are reliably moved inwardly from the positions "1" and "3" so that the respective processing nests 131 are completely clear of the incoming coming conveyor 111 and outgoing conveyor 113 for subsequent moving operations.

In a second processing nest moving operation 610, all four processing nests 131 are substantially simultaneously moved along the paths "A4" via their respective movers 144 of the actuator assembly 140 as shown in Figure 7B. In this configuration, the processing nests 131 that were originally positioned in the loading/unloading positions "1" and "3" are moved along the path "A4" to the respective processing positions "2" and "4" via their respective mover 144. Concurrently, the processing nests 131 that were originally positioned in the processing positions "2" and "4" are moved along the path "A4" to positions inward of the respective loading/unloading positions "1" and "3" via their respective mover. The system controller 101 is used to coordinate the movement of all four movers 144 of the actuator assembly 140 to assure that all four processing nests 131 are reliably moved substantially simultaneously for the next operation in the sequence 600. Since the position of each of the movers 144 can be independently controlled, it may be desirable to position one or two movers 144 at a time rather than four at a time as schematically illustrated in Figure 7B.

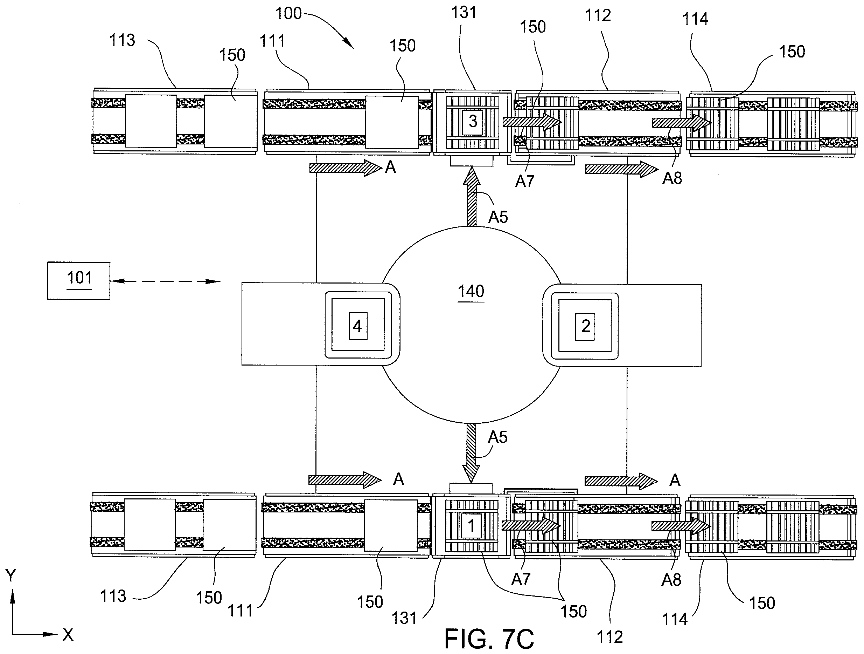

In a third processing nest moving operation 612, the processing nests 131 positioned inwardly from the respective loading/unloading positions "1" and "3" are moved outwardly along paths "A5" into the loading/unloading positions "1" and "3" via their respective movers 144 of the actuator assembly 140 as shown in Figure 7C. The system controller 101 is used to coordinate the movement of the movers 144 of the actuator assembly 140 to assure that the processing nests 131 are reliably moved into the positions "1" and "3" so that the respective processing nests 131 are aligned with the incoming coming conveyor 111 and outgoing conveyor 113 for subsequent unloading/loading operations.

Concurrently, in an alignment operation 614, the substrates 150 located on the processing nests 131 positioned in the processing positions "2" and "4" shown in Figure 7C are precisely aligned for a subsequent processing operation. In one embodiment, the location and orientation data of each substrate 150 on each respective processing nest 131 collected by the inspection system 200 in the inspection operation 606 is used by the system controller 101 to position and orient the components in the processing head 102 to improve the accuracy of the subsequent process.

In the embodiment, wherein the system 100 is a screen printing system, the location and orientation data may be used to position and orient the screen print components of the processing head 102 to improve the accuracy of the screen printing process. In one embodiment, the position of a printing mask contained in each of the processing heads 102 is automatically adjusted in both the X-Y directions and the angular orientation to align the printing mask of the processing head 102 to a desired position over the substrate 150 positioned on the processing nest 131 based on the data received during the inspection step 606. In another embodiment, the location and orientation data collected by the inspection system 200 for each substrate 150 on each processing nest 131 is used by the system controller 101 to precisely position each processing nest 131 relative to the printing mask in each processing head 102 in the X-Y directions via the respective mover 144 and to angularly adjust the orientation of the print mask in the processing head 102 to a desired position and orientation relative to the substrate 150 positioned on the processing nest 131 using one or more of the actuators 105.

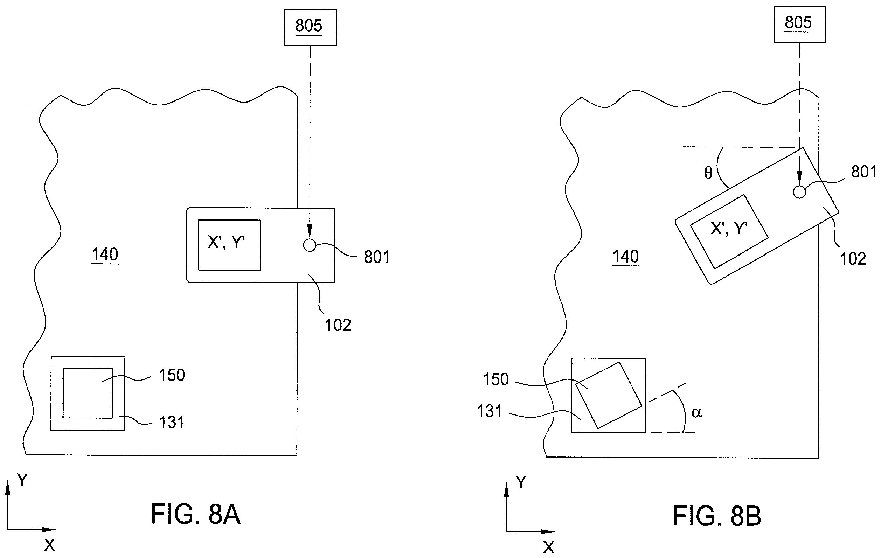

In one embodiment, the location and orientation data collected by the inspection system 200 for each substrate 150 on each processing nest 131 is used by the system controller 101 to precisely position each processing nest 131 in the X-Y directions via the respective mover 144 and to angularly adjust the orientation of the processing head 102 to a desired orientation relative to the substrate 150 positioned on the processing nest 131. For instance, as shown in Figure 8A, the ideal positioning of a processing nest 131 having a perfectly aligned substrate 150 positioned thereon corresponds with a location having coordinates X' and Y'. At this location, no angular manipulation of the processing head 102 is needed. However, as shown in Figure 8B, a substrate 150 is positioned at an angle α with respect to the processing nest 131. Based on this orientation information, as obtained from the inspection system 200, the system controller 101 determines that the correct positioning of the substrate corresponds with a location having the coordinates X" and Y". Correspondingly, the respective mover 144 is moved to the position X" and Y". Further, the system controller 101 determines whether the processing head 102 should be rotated to compensate for the angular misorientation of the substrate 150 on the processing nest 131. Based on this information, the processing head 102 is rotated about a pivot 801 an angle θ via use of an actuator 805 (*e.g.,* stepper motor, servo motor) and the system controller 101. In one embodiment, the angle θ calculated by the system controller 101 is substantially equal to the angle α measured by the inspection system 200. Thus, the substrate 150 is precisely positioned for processing by the combination of adjusting the X-Y position of the mover 144 and the angular positioning of the processing head 102.

In another embodiment, the location and orientation data for each substrate 150 disposed on each processing nest 131 is collected and used by the system controller 101 to precisely position each processing nest 131 under each processing head 102 in the X-Y directions via the respective mover 144 and to angularly align the substrate 150 disposed on each processing nest 131 to the processing head 102 using the respective rotary actuator 148 coupled to the processing nest 131 and the mover 144. In this configuration, all adjustment for the position and orientation of the substrate 150 is compensated for by each processing nest 131, thereby allowing processing of multiple substrates 150 (each configured on an individual processing nest 131) in a single processing operation by a single screen processing head 102, as subsequently described below.

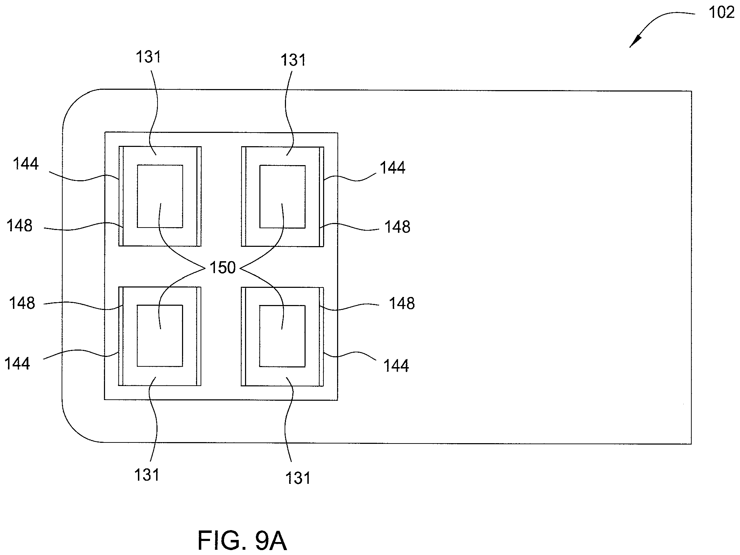

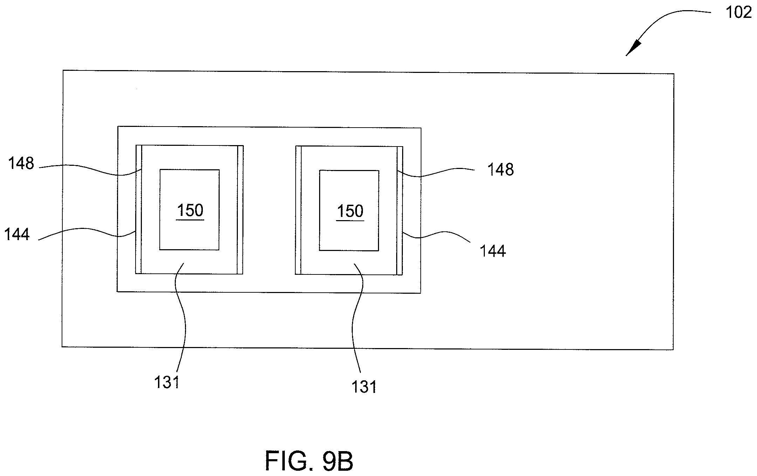

Figures 9A and 9B are plan views depicting a single processing head 102 having multiple processing nests 131, each supporting a substrate 150, positioned thereunder for a substrate processing operation according to one embodiment of the present invention. Figure 9A is a plan view depicting a single processing head 102 having four processing nests 131, each supporting a substrate 150, positioned thereunder for a processing operation according to one embodiment of the present invention. Figure 9B is a plan view depicting a single screen processing head 102 having two processing nests 131, each supporting a substrate 150, positioned thereunder for a processing operation according to one embodiment of the present invention. In these embodiments, the location and orientation data of each substrate 150 positioned on each processing nest 131 is used by the system controller 101 to precisely position the substrate 150 under the processing head 102 in the X-Y directions via the respective mover 144 and to precisely angularly align the substrate 150 via the respective rotary actuator 148. Although Figures 9A and 9B depict four and two processing nests 131 under a processing head 102 for substantially simultaneous alignment and processing, any number of processing nests 131 may be used depending on the desired throughput and the desired footprint of the overall system 100.

In a processing operation 616, a process, such as screen printing, ink jet printing, laser ablation, or the like, is performed on the first pair of substrates 150 precisely positioned in processing positions "2" and "4" as shown in Figure 7C. In one embodiment, the process is a screen printing process that takes about two seconds to complete and is controlled via commands from the system controller 101. In one embodiment, to improve system throughput, while the processing operation 616 is being performed, operations 602-608 are being repeated for a second pair of substrates 150. That is, a second pair of substrates 150 is first transferred from the input conveyors 113 to the incoming conveyors 111 in a second operation 602. Each of the second pair of substrates 150 are loaded onto the processing nests 131 located in positions "1" and "3" in a second operation 604. Here again, in steady state operation, processed substrates 150 are located on the processing nests 131, which are unloaded as the second pair of unprocessed substrates 150 are loaded. Each of the second pair of substrates 150 are inspected via the inspection system 200 in a second operation 606. Then, each of the processing nests 131 supporting the second pair of substrates 150 is moved inwardly along the path "A3" in a second operation 608.

In a fourth processing nest moving operation 618, each of the processing nests 131, located in the processing positions "2" and "4" and supporting a processed substrate 150, is moved along the path "A4" via its respective mover 144 of the actuator assembly 140 as shown in Figure 7B. Concurrently, each of the processing nests 131 located inwardly from the loading/unloading positions "1" and "3" and supporting a newly loaded substrate 150, is moved along the path "A4" where the aligning operation 614 and the processing operation 616 are then performed on the substrates 150 in the processing positions "2" and "4". The system controller 101 is used to coordinate the movement of all four movers 144 of the actuator assembly 140 to assure that all four processing nests 131 are reliably moved substantially simultaneously for the next operation in the sequence 600.

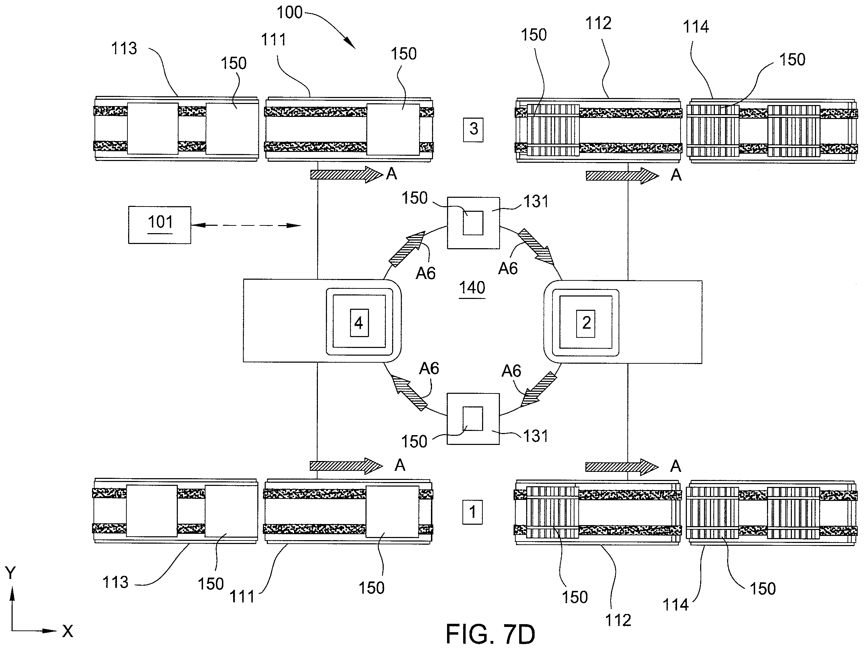

In an alternate fourth processing nest moving operation 618, each of the processing nests 131, located in the processing positions "2" and "4" and supporting a processed substrate 150, is moved back along the path "A6" to its previous location inboard of its respective loading/unloading position "1" or "3" via its respective mover 144 of the actuator assembly 140 as shown in Figure 7D. Concurrently, each of the processing nests 131 located inwardly from the loading/unloading positions "1" or "3" and supporting a newly loaded substrate 150, is moved along the path "A6" to its respective processing head 102, where the aligning operation 614 and the processing operation 616 are then performed on the substrates 150 in the processing positions "2" and "4". The system controller 101 is used to coordinate the movement of all four movers 144 of the actuator assembly 140 to assure that all four processing nests 131 are reliably moved substantially simultaneously for the next operation in the sequence 600.

In a fifth processing nest moving operation 620, the processing nests 131 supporting the processed substrates 150 and located inwardly from the loading/unloading positions "1" and "3" are moved outwardly along paths "A5" via their respective mover 144 of the actuator assembly 140 as shown in Figure 7C. The system controller 101 is used to coordinate the movement of the movers 144 of the actuator assembly 140 to assure that the processing nests 131 are reliably moved into the positions "1" and "3" so that the respective processing nests 131 are aligned with the incoming coming conveyor 111 and outgoing conveyor 113 for subsequent unloading/loading operations.

In an unloading operation 622, each of the first pair of processed substrates 150 supported by the processing nests 131 located in the loading/unloading positions "1" and "3" is unloaded onto the respective outgoing conveyor 112 as shown in Figure 7C. In this configuration, each processed substrate 150 is transferred from the material 137 of the conveyor 139 in the processing nest 131 to the belts 116 of the incoming conveyors 111 following the transfer path "A7". Concurrently, unprocessed substrates 150 are loaded onto the processing nests 131 as previously described in operation 604. The system controller 101 is used to coordinate the motion of the belts 116 and feed rollers 133 (Figure 5B) or feed spool 135 and take-up spool 136 (Figured 5A) for reliably unloading the processed substrates 150 from the processing nests 131 and positioning the unprocessed substrates 150 onto the processing nests 131.

Finally, in a substrate transferring operation 624, the first pair of processed substrates 150 is transferred along the paths "A8" from the outgoing conveyors 112 to the output conveyors 114 as shown in Figure 7C. In this configuration, the system controller 101 is used to coordinate the motion of the belts 116 and drive actuators (not shown) in each outgoing conveyor 112 and output conveyor 114 so that the substrates 150 are reliably transferred between these automation components.

In steady state operation, the operations 602-624 of the operating sequence 600 are continually repeated for continuous processing of substrates 150 in a production line environment. The number and sequence of operations illustrated in Figure 6 are not intended to limit the scope of the invention described herein, since one or more operations can be deleted and/or reordered without deviating from the basic scope of the invention described herein. Additionally, the schematic representation of the operations shown in Figures 7A-7D is not intended to limit the scope of the invention described, since the operations need not be completed in a sequential fashion as pictorially shown, and two or more of the operations can be completed simultaneously.

In addition to the above described movement of each substrate 150 between the loading/unloading positions "1" and "3" and the processing positions "2" and "4", a number of other alternative transfer paths are embodied within the scope of the present invention. In one embodiment, the processing nests 131 that are initially located in positions "1" and "2" continually exchange positions in the loading, processing, and unloading operations. Concurrently, the processing nests 131 that are initially located in positions "3" and "4" continually exchange positions in the loading, processing, and unloading operations.

In another embodiment, the processing nest 131 that is initially located in the loading/unloading position "1," moves to printing position "2" and then back to the loading/unloading position "1." Concurrently, the processing nest 131 that is initially located in the loading/unloading position "3," moves to processing position "4" and then back to the loading/unloading position "3." These movements are continually repeated throughout the processing sequence.

In yet another embodiment, the printing nest 131 that is initially located in the loading/unloading position "1," moves to processing position "2" and then moves to the loading/unloading position "3" as previously described. The processing nest 131 then moves back to processing position "2" and then moves back to the loading/unloading position "1". Concurrently, the processing nest 131 that is initially located in the loading/unloading position "3," moves to processing position "4" and then moves to the loading/unloading position "1." The processing nest 131 then moves back to processing position "4" and then moves back to the loading/unloading position "3." These movements are continually repeated throughout the processing sequence.

While the foregoing is directed to embodiments of the present invention, other and further embodiments of the invention may be devised without departing from the basic scope thereof, and the scope thereof is determined by the claims that follow.

## Claims

1. An apparatus for processing a substrate (150), comprising:
a planar stator (142);
a first mover (144) positioned on the planar stator (142);
a second mover (144) positioned on the planar stator (142), wherein the first and second movers (144) are configured to move laterally and longitudinally over the planar stator (142) in a horizontal plane independently of one another;
a first substrate support (131) coupled to the first mover (144) and positionable to receive a substrate (150) in a substrate loading position;
a second substrate support (131) coupled to the second mover (144) and positionable to receive a substrate (150) in the substrate loading position;
a processing head (102) configured to process a first substrate (150) positioned on the first substrate support (131) when the first substrate support (131) is in a first substrate processing position, wherein the processing head (102) is further configured to process a second substrate (150) positioned on the second substrate support (131) when the second substrate support (131) is in a second substrate processing position, wherein the processing head is configured to deposit a patterned layer on the first and second substrates; and
an inspection system (200) configured to capture data regarding the position and orientation of the first substrate (150) disposed on the first substrate support (131) when the first substrate support (131) is in the substrate loading position and to capture data regarding the position and orientation of the second substrate (150) disposed on the second substrate support (131) when the second substrate support (131) is in the substrate loading position;
wherein the apparatus is configured to move the first substrate support from the substrate support loading position to the first substrate processing position at least partially based on the data captured by the inspection system via the planar stator and the first mover and wherein the apparatus is configured to move the second substrate support from the substrate loading position to the second substrate processing position at least partially based on the data captured by the inspection system via the planar stator and the second mover.

2. The apparatus as in claim 1, wherein said processing comprises one or the other between screen printing, inkjet printing, laser ablation or laser etching.

3. The apparatus of claim 2, wherein the processing head (102) further comprises one or more actuators (105) configured to adjust components in the processing head (102) laterally, longitudinally, and angularly based on the data captured by the inspection system (200).

4. The apparatus of claim 2, wherein the processing head (102) further comprises one or more actuators (105, 805) configured to adjust components in the processing head (102) angularly based on the data captured by the inspection system (200).

5. The apparatus of claim 1, wherein each of the first and second substrate supports (131) further comprises a continuous conveyor (139) configured to assist in loading and unloading a substrate (150).

6. An apparatus for processing a substrate (150), comprising:
a planar stator (142);
a first mover (144) positioned on the planar stator (142); a second mover (144) positioned on the planar stator (142), wherein the first and second movers (144) are configured to move laterally and longitudinally over the planar stator (142) in a horizontal plane independently of one another;
a first substrate support (131) coupled to the first mover (144) and positioned to receive a first substrate (150) in a first substrate loading position;
a second substrate support (131) coupled to the second mover (144) and positioned to receive a second substrate (150) in a second substrate loading position;
a first processing head (102) configured to process the first substrate (150) positioned on the first substrate support (131) when the first substrate support (131) is in a first substrate processing position; and
a second processing head (102) configured to process the second substrate (150) positioned on the second substrate support (131) when the second substrate support (131) is in a second substrate processing position;
a first inspection system (200) configured to capture data regarding the position and orientation of the first substrate (150) disposed on the first substrate support (131) when the first substrate support (131) is in the first substrate loading position; and
a second inspection system (200) configured to capture data regarding the position and orientation of the second substrate (150) disposed on the second substrate support (131) when the second substrate support (131) is in the second substrate loading position;
wherein the apparatus is configured to move the first substrate support from the first substrate loading position to the first substrate processing position at least partially based on the data captured by the first inspection system via the planar stator and the first mover, and wherein the apparatus is configured to move the second substrate support from the second substrate loading position to the second substrate processing position at least partially based on the data captured by the second inspection system via the planar stator and the second mover,
and wherein the first processing head is configured to deposit a patterned layer on the first substrate positioned on the first substrate support when the first substrate support is in the first substrate processing position, and wherein the second processing head is configured to deposit a patterned layer on the second substrate positioned on the second substrate support when the second substrate support is in the second substrate processing position.

7. The apparatus of claim 6, wherein the apparatus further comprises:
a third mover (144) positioned on the planar stator (142);
a fourth mover (144) positioned on the planar stator (142), wherein the first, second, third, and fourth movers (144) are configured to move laterally and longitudinally over the planar stator (142) in a horizontal plane independently of one another;
a third substrate support (131) coupled to the third mover (144) and positionable to receive a substrate (150) in the first substrate loading position; and
a fourth substrate support (131) coupled to the fourth mover (144) and positionable to receive a substrate (150) in the second substrate loading position.

8. The apparatus of claim 7, wherein the first processing head (102) is configured to deposit a patterned layer on a substrate (150) positioned on the third substrate support (131) when the third substrate support (131) is in a third substrate processing position, and wherein the second processing head (102) is configured to deposit a patterned layer on a substrate (150) positioned on the fourth substrate support (131) when the fourth substrate support (131) is in a fourth substrate processing position.

9. The apparatus of claim 8, wherein the first inspection system (200) is further configured to capture data regarding the position and orientation of a substrate (150) disposed on the third substrate support (131) when the third substrate support (131) is in the first substrate loading position, and wherein the second inspection system (200) is further configured to capture data regarding the position and orientation of a substrate (150) disposed on the fourth substrate support (131) when the fourth substrate support (131) is in the second substrate loading position.

10. The apparatus of claim 9, wherein the apparatus is configured to move the third substrate support (131) from the first substrate loading position to the third substrate processing position at least partially based on the data captured by the first inspection system (200) via the planar stator (142) and the third mover (144), and wherein the apparatus is configured to move the fourth substrate support (131) from the second substrate loading position to the fourth substrate processing position at least partially based on the data captured by the second inspection system (200) via the planar stator (142) and the fourth mover (144).

11. The apparatus of claim 10, wherein the first processing head (102) comprises one or more actuators (105, 805) configured to angularly position components in the first processing head (102) based on data captured by the first inspection system (200), and wherein the second processing head (102) comprises one or more actuators (105, 805) configured to angularly position components in the second processing head (102) based on data captured by the second inspection system (200).

12. The apparatus of claim 11, wherein each of the first and third substrate supports (131) further comprise an actuator configured to angularly adjust the first or third substrate support (131) based on data captured by the first inspection system (200), and wherein each of the second and fourth substrate supports (131) further comprise an actuator configured to angularly adjust the second or fourth substrate support (131) based on data captured by the second inspection system (200).

13. A method for processing a substrate (150), comprising:
orienting a first substrate support (131) in a first substrate loading position via a planar stator (142) and a first mover (144) attached to the first substrate support (131);
orienting a second substrate support (131) in a second substrate loading position via the planar stator (142) and a second mover (144) attached to the second substrate support (131);
receiving a first substrate (150) on the first substrate support (131);
capturing data via a first inspection system (200) regarding the position and orientation of the first substrate (150) on the first substrate support (131);
receiving a second substrate (150) on the second substrate support (131);
capturing data via a second inspection system (200) regarding the position and orientation of the second substrate (150) on the second substrate support (131);
moving the first substrate support (131) from the first substrate loading position to a first substrate processing position at least partially based on the data captured by the first inspection system (200) via the planar stator (142) and the first mover (144);
angularly orienting the first substrate support (131) via an actuator coupled to the first substrate support (131) prior to processing the first substrate;
processing the first substrate (150) via a first processing head (102), wherein the first processing head is configured to deposit a patterned layer on the first substrate positioned on the first substrate support when the first substrate support is in the first substrate processing position;
moving the second substrate support (131) from the second substrate loading position to a second substrate processing position at least partially based on the data captured by the first inspection system (200) via the planar stator (142) and the second mover (144);
angularly orienting the second substrate support (131) via an actuator coupled to the second substrate support (131) prior to processing the second substrate; and
processing the second substrate (150) via a second processing head (102), wherein the second processing head is configured to deposit a patterned layer on the second substrate positioned on the second substrate support when the second substrate support is in the second substrate processing position.

14. The process of claim 13, further comprising:
angularly orienting components in the first processing head (102) based on data captured by the first inspection system (200) prior to processing the first substrate (150); and
angularly orienting components in the second processing head (102) based on data captured by the second inspection system (200) prior to processing the second substrate (150).

## Patentansprüche

1. Vorrichtung zum Bearbeiten eines Substrats (150), Folgendes umfassend:
einen ebenflächigen Ständer (142);
eine erste Bewegungsvorrichtung (144), die auf dem ebenflächigen Ständer (142) positioniert ist;
eine zweite Bewegungsvorrichtung (144), die auf dem ebenflächigen Ständer (142) positioniert ist, wobei die erste und zweite Bewegungsvorrichtung (144) dazu ausgelegt sind, sich unabhängig voneinander seitlich und längs über den ebenflächigen Ständer (142) in einer horizontalen Ebene zu bewegen;
eine erste Substrathalterung (131), die an die erste Bewegungsvorrichtung (144) angeschlossen und positionierbar ist, um ein Substrat (150) in einer Substratladeposition aufzunehmen;
eine zweite Substrathalterung (131), die an die zweite Bewegungsvorrichtung (144) angeschlossen und positionierbar ist, um ein Substrat (150) in der Substratladeposition aufzunehmen;
einen Bearbeitungskopf (102), der dazu ausgelegt ist, ein erstes, auf der ersten Substrathalterung (131) positioniertes Substrat (150) zu bearbeiten, wenn sich die erste Substrathalterung (131) in einer ersten Substratbearbeitungsposition befindet, wobei der Bearbeitungskopf (102) darüber hinaus dazu ausgelegt ist, ein zweites, auf der zweiten Substrathalterung (131) positioniertes Substrat (150) zu bearbeiten, wenn sich die zweite Substrathalterung (131) in einer zweiten Substratbearbeitungsposition befindet, wobei der Bearbeitungskopf dazu ausgelegt ist, eine strukturierte Schicht auf dem ersten und zweiten Substrat abzuscheiden; und
ein Inspektionssystem (200), das dazu ausgelegt ist, Daten hinsichtlich der Position und Ausrichtung des ersten, auf der ersten Substrathalterung (131) angeordneten Substrats (150) zu erfassen, wenn sich die erste Substrathalterung (131) in der Substratladeposition befindet, und Daten hinsichtlich der Position und Ausrichtung des zweiten, auf der zweiten Substrathalterung (131) angeordneten Substrats (150) zu erfassen, wenn sich die zweite Substrathalterung (131) in der Substratladeposition befindet;
wobei die Vorrichtung dazu ausgelegt ist, die erste Substrathalterung von der Substratladeposition zur ersten Substratbearbeitungsposition zumindest teilweise auf Grundlage der Daten zu bewegen, die durch das Inspektionssystem über den ebenflächigen Ständer und die erste Bewegungsvorrichtung erfasst wurden, und wobei die Vorrichtung dazu ausgelegt ist, die zweite Substrathalterung von der Substratladeposition zur zweiten Substratbearbeitungsposition zumindest teilweise auf Grundlage der Daten zu bewegen, die durch das Inspektionssystem über den ebenflächigen Ständer und die zweite Bewegungsvorrichtung erfasst wurden.

2. Vorrichtung nach Anspruch 1, wobei die Bearbeitung wahlweise Siebdrucken, Tintenstrahldrucken, Laserablation oder Laserätzen umfasst.

3. Vorrichtung nach Anspruch 2, wobei der Bearbeitungskopf (102) darüber hinaus ein oder mehrere Stellglied/er (105) umfasst, das/die dazu ausgelegt ist/sind, Komponenten im Bearbeitungskopf (102) auf Grundlage der durch das Inspektionssystem (200) erfassten Daten seitlich, längs oder winkelbezogen einzustellen.

4. Vorrichtung nach Anspruch 2, wobei der Bearbeitungskopf (102) darüber hinaus ein oder mehrere Stellglied/er (105, 805) umfasst, das/die dazu ausgelegt ist/sind, Komponenten im Bearbeitungskopf (102) auf Grundlage der durch das Inspektionssystem (200) erfassten Daten winkelbezogen einzustellen.

5. Vorrichtung nach Anspruch 1, wobei die erste und zweite Substrathalterung (131) jeweils einen Stetigförderer (139) umfasst, der dazu ausgelegt ist, beim Beladen und Entnehmen eines Substrats (150) behilflich zu sein.

6. Vorrichtung zum Bearbeiten eines Substrats (150), Folgendes umfassend:
einen ebenflächigen Ständer (142);
eine erste Bewegungsvorrichtung (144), die auf dem ebenflächigen Ständer (142) positioniert ist; eine zweite Bewegungsvorrichtung (144), die auf dem ebenflächigen Ständer (142) positioniert ist, wobei die erste und zweite Bewegungsvorrichtung (144) dazu ausgelegt sind, sich unabhängig voneinander seitlich und längs über den ebenflächigen Ständer (142) in einer horizontalen Ebene zu bewegen;
eine erste Substrathalterung (131), die an die erste Bewegungsvorrichtung (144) angeschlossen und positioniert ist, um ein erstes Substrat (150) in einer ersten Substratladeposition aufzunehmen;
eine zweite Substrathalterung (131), die an die zweite Bewegungsvorrichtung (144) angeschlossen und positioniert ist, um ein zweites Substrat (150) in einer zweiten Substratladeposition aufzunehmen;
einen ersten Bearbeitungskopf (102), der dazu ausgelegt ist, das erste, auf der ersten Substrathalterung (131) positionierte Substrat (150) zu bearbeiten, wenn sich die erste Substrathalterung (131) in einer ersten Substratbearbeitungsposition befindet, und
und einen zweiten Bearbeitungskopf (102), der dazu ausgelegt ist, das zweite, auf der zweiten Substrathalterung (131) positionierte Substrat (150) zu bearbeiten, wenn sich die zweite Substrathalterung (131) in einer zweiten Substratbearbeitungsposition befindet;
ein erstes Inspektionssystem (200), das dazu ausgelegt ist, Daten hinsichtlich der Position und Ausrichtung des ersten, auf der ersten Substrathalterung (131) angeordneten Substrats (150) zu erfassen, wenn sich die erste Substrathalterung (131) in der ersten Substratladeposition befindet, und
ein zweites Inspektionssystem (200), das dazu ausgelegt ist, Daten hinsichtlich der Position und Ausrichtung des zweiten, auf der zweiten Substrathalterung (131) angeordneten Substrats (150) zu erfassen, wenn sich die zweite Substrathalterung (131) in der zweiten Substratladeposition befindet;
wobei die Vorrichtung dazu ausgelegt ist, die erste Substrathalterung von der ersten Substratladeposition zur ersten Substratbearbeitungsposition zumindest teilweise auf Grundlage der Daten zu bewegen, die durch das erste Inspektionssystem über den ebenflächigen Ständer und die erste Bewegungsvorrichtung erfasst wurden, und wobei die Vorrichtung dazu ausgelegt ist, die zweite Substrathalterung von der zweiten Substratladeposition zur zweiten Substratbearbeitungsposition zumindest teilweise auf Grundlage der Daten zu bewegen, die durch das zweite Inspektionssystem über den ebenflächigen Ständer und die zweite Bewegungsvorrichtung erfasst wurden,
und wobei der erste Bearbeitungskopf dazu ausgelegt ist, eine strukturierte Schicht auf dem ersten, auf der ersten Substrathalterung positionierten Substrat abzuscheiden, wenn sich die erste Substrathalterung in der ersten Substratbearbeitungsposition befindet, und wobei der zweite Bearbeitungskopf dazu ausgelegt ist, eine strukturierte Schicht auf dem zweiten, auf der zweiten Substrathalterung positionierten Substrat abzuscheiden, wenn sich die zweite Substrathalterung in der zweiten Substratbearbeitungsposition befindet.

7. Vorrichtung nach Anspruch 6, wobei die Vorrichtung darüber hinaus umfasst:
eine dritte Bewegungsvorrichtung (144), die auf dem ebenflächigen Ständer (142) positioniert ist;
eine vierte Bewegungsvorrichtung (144), die auf dem ebenflächigen Ständer (142) positioniert ist, wobei die erste, zweite, dritte und vierte Bewegungsvorrichtung (144) dazu ausgelegt sind, sich unabhängig voneinander seitlich und längs über den ebenflächigen Ständer (142) in einer horizontalen Ebene zu bewegen;
eine dritte Substrathalterung (131), die an die dritte Bewegungsvorrichtung (144) angeschlossen und positionierbar ist, um ein Substrat (150) in der ersten Substratladeposition aufzunehmen; und
eine vierte Substrathalterung (131), die an die vierte Bewegungsvorrichtung (144) angeschlossen und positionierbar ist, um ein Substrat (150) in der zweiten Substratladeposition aufzunehmen.

8. Vorrichtung nach Anspruch 7, wobei der erste Bearbeitungskopf (102) dazu ausgelegt ist, eine strukturierte Schicht auf einem auf der dritten Substrathalterung (131) positionierten Substrat (150) abzuscheiden, wenn sich die dritte Substrathalterung (131) in einer dritten Substratbearbeitungsposition befindet, und wobei der zweite Bearbeitungskopf (102) dazu ausgelegt ist, eine strukturierte Schicht auf einem auf der vierten Substrathalterung (131) positionierten Substrat (150) abzuscheiden, wenn sich die vierte Substrathalterung (131) in einer vierten Substratbearbeitungsposition befindet.

9. Vorrichtung nach Anspruch 8, wobei das erste Inspektionssystem (200) darüber hinaus dazu ausgelegt ist, Daten hinsichtlich der Position und Ausrichtung eines auf der dritten Substrathalterung (131) angeordneten Substrats (150) zu erfassen, wenn sich die dritte Substrathalterung (131) in der ersten Substratladeposition befindet, und wobei das zweite Inspektionssystem (200) darüber hinaus dazu ausgelegt ist, Daten hinsichtlich der Position und Ausrichtung eines auf der vierten Substrathalterung (131) angeordneten Substrats (150) zu erfassen, wenn sich die vierte Substrathalterung (131) in der zweiten Substratladeposition befindet.

10. Vorrichtung nach Anspruch 9, wobei die Vorrichtung dazu ausgelegt ist, die dritte Substrathalterung (131) von der ersten Substratladeposition zur dritten Substratbearbeitungsposition zumindest teilweise auf Grundlage der Daten zu bewegen, die durch das erste Inspektionssystem (200) über den ebenflächigen Ständer (142) und die dritte Bewegungsvorrichtung (144) erfasst wurden, und wobei die Vorrichtung dazu ausgelegt ist, die vierte Substrathalterung (131) von der zweiten Substratladeposition zur vierten Substratbearbeitungsposition zumindest teilweise auf Grundlage der Daten zu bewegen, die durch das zweite Inspektionssystem (200) über den ebenflächigen Ständer (142) und die vierte Bewegungsvorrichtung (144) erfasst wurden.

11. Vorrichtung nach Anspruch 10, wobei der erste Bearbeitungskopf (102) ein oder mehrere Stellglied/er (105, 805) umfasst, das/die dazu ausgelegt ist/sind, Komponenten im ersten Bearbeitungskopf (102) auf Grundlage von durch das erste Inspektionssystem (200) erfassten Daten winkelbezogen zu positionieren, und wobei der zweite Bearbeitungskopf (102) ein oder mehrere Stellglied/er (105, 805) umfasst, das/die dazu ausgelegt ist/sind, Komponenten im zweiten Bearbeitungskopf (102) auf Grundlage von durch das zweite Inspektionssystem (200) erfassten Daten winkelbezogen zu positionieren.

12. Vorrichtung nach Anspruch 11, wobei die erste und dritte Substrathalterung (131) darüber hinaus jeweils ein Stellglied umfassen, das dazu ausgelegt ist, die erste oder dritte Substrathalterung (131) auf Grundlage von durch das erste Inspektionssystem (200) erfassten Daten winkelbezogen einzustellen, und wobei die zweite und vierte Substrathalterung (131) darüber hinaus jeweils ein Stellglied umfassen, das dazu ausgelegt ist, die zweite oder vierte Substrathalterung (131) auf Grundlage von durch das zweite Inspektionssystem (200) erfassten Daten winkelbezogen einzustellen.

13. Verfahren zum Bearbeiten eines Substrats (150), Folgendes umfassend:
Ausrichten einer ersten Substrathalterung (131) in einer ersten Substratladeposition mittels eines ebenflächigen Ständers (142) und einer an der ersten Substrathalterung (131) befestigten ersten Bewegungsvorrichtung (144);
Ausrichten einer zweiten Substrathalterung (131) in einer zweiten Substratladeposition mittels des ebenflächigen Ständers (142) und einer an der zweiten Substrathalterung (131) befestigten zweiten Bewegungsvorrichtung (144);
Aufnehmen eines ersten Substrats (150) auf der ersten Substrathalterung (131);
Erfassen von Daten über ein erstes Inspektionssystem (200) hinsichtlich der Position und Ausrichtung des ersten Substrats (150) auf der ersten Substrathalterung (131);
Aufnehmen eines zweiten Substrats (150) auf der zweiten Substrathalterung (131);
Erfassen von Daten über ein zweites Inspektionssystem (200) hinsichtlich der Position und Ausrichtung des zweiten Substrats (150) auf der zweiten Substrathalterung (131);
Bewegen der ersten Substrathalterung (131) von der ersten Substratladeposition zu einer ersten Substratbearbeitungsposition zumindest teilweise auf Grundlage der durch das erste Inspektionssystem (200) über den ebenflächigen Ständer (142) und die erste Bewegungsvorrichtung (144) erfassten Daten;
winkelbezogenes Ausrichten der ersten Substrathalterung (131) über ein an die erste Substrathalterung (131) angeschlossenes Stellglied, vor der Bearbeitung des ersten Substrats;
Bearbeiten des ersten Substrats (150) über einen ersten Bearbeitungskopf (102), wobei der erste Bearbeitungskopf dazu ausgelegt ist, eine strukturierte Schicht auf dem ersten, auf der ersten Substrathalterung positionierten Substrat abzuscheiden, wenn sich die erste Substrathalterung in der ersten Substratbearbeitungsposition befindet;
Bewegen der zweiten Substrathalterung (131) von der zweiten Substratladeposition zu einer zweiten Substratbearbeitungsposition zumindest teilweise auf Grundlage der durch das erste Inspektionssystem (200) über den ebenflächigen Ständer (142) und die zweite Bewegungsvorrichtung (144) erfassten Daten;
winkelbezogenes Ausrichten der zweiten Substrathalterung (131) über ein an die zweite Substrathalterung (131) angeschlossenes Stellglied, vor der Bearbeitung des zweiten Substrats; und
Bearbeiten des zweiten Substrats (150) über einen zweiten Bearbeitungskopf (102), wobei der zweite Bearbeitungskopf dazu ausgelegt ist, eine strukturierte Schicht auf dem zweiten, auf der zweiten Substrathalterung positionierten Substrat abzuscheiden, wenn sich die zweite Substrathalterung in der zweiten Substratbearbeitungsposition befindet.

14. Verfahren nach Anspruch 13, darüber hinaus umfassend:
winkelbezogenes Ausrichten von Komponenten im ersten Bearbeitungskopf (102) auf Grundlage von durch das erste Inspektionssystem (200) erfassten Daten, vor der Bearbeitung des ersten Substrats (150); und
winkelbezogenes Ausrichten von Komponenten im zweiten Bearbeitungskopf (102) auf Grundlage von durch das zweite Inspektionssystem (200) erfassten Daten, vor der Bearbeitung des zweiten Substrats (150).

## Revendications

1. Appareil destiné au traitement d'un substrat (150), comprenant:
un stator plan (142) ;
un premier dispositif de déplacement (144) positionné sur le stator plan (142);
un deuxième dispositif de déplacement (144) positionné sur le stator plan (142), sachant que le premier et le deuxième dispositif de déplacement (144) sont configurés pour se déplacer latéralement et longitudinalement sur le stator plan (142) dans un plan horizontal indépendamment l'un de l'autre;
un premier support de substrat (131) couplé au premier dispositif de déplacement (144) et positionnable pour recevoir un substrat (150) dans une position de chargement de substrat;
un deuxième support de substrat (131) couplé au deuxième dispositif de déplacement (144) et positionnable pour recevoir un substrat (150) dans la position de chargement de substrat;
une tête de traitement (102) configurée pour traiter un premier substrat (150) positionné sur le premier support de substrat (131) lorsque le premier support de substrat (131) se trouve dans une première position de traitement de substrat, sachant que la tête de traitement (102) est en outre configurée pour traiter un deuxième substrat (150) positionné sur le deuxième support de substrat (131) lorsque le deuxième support de substrat (131) se trouve dans une deuxième position de traitement de substrat, sachant que la tête de traitement est configurée pour déposer une couche texturée sur le premier et le deuxième substrat; et
un système d'inspection (200) configuré pour capturer des données concernant la position et l'orientation du premier substrat (150) disposé sur le premier support de substrat (131) lorsque le premier support de substrat (131) se trouve dans la position de chargement de substrat et pour capturer des données concernant la position et l'orientation du deuxième substrat (150) disposé sur le deuxième support de substrat (131) lorsque le deuxième support de substrat (131) se trouve dans la position de chargement de substrat;
sachant que l'appareil est configuré pour déplacer le premier support de substrat de la position de chargement de substrat à la première position de traitement de substrat au moins en partie sur la base des données capturées par le système d'inspection via le stator plan et le premier dispositif de déplacement et sachant que l'appareil est configuré pour déplacer le deuxième support de substrat de la position de chargement de substrat à la deuxième position de traitement de substrat au moins en partie sur la base des données capturées par le système d'inspection via le stator plan et le deuxième dispositif de déplacement.

2. L'appareil tel que revendiqué dans la revendication 1, sachant que ledit traitement comprend l'un ou l'autre parmi la sérigraphie, l'impression par jet d'encre, l'ablation au laser ou la gravure au laser.

3. L'appareil de la revendication 2, sachant que la tête de traitement (102) comprend en outre un ou plusieurs actionneurs (105) configurés pour régler latéralement, longitudinalement, ou angulairement des composants dans la tête de traitement (102) sur la base des données capturées par le système d'inspection (200).

4. L'appareil de la revendication 2, sachant que la tête de traitement (102) comprend en outre un ou plusieurs actionneurs (105, 805) configurés pour régler angulairement des composants dans la tête de traitement (102) sur la base des données capturées par le système d'inspection (200).

5. L'appareil de la revendication 1, sachant que chacun du premier et du deuxième support de substrat (131) comprend en outre un convoyeur continu (139) configuré pour assister au chargement et au déchargement d'un substrat (150).

6. Appareil destiné au traitement d'un substrat (150), comprenant :
un stator plan (142);
un premier dispositif de déplacement (144) positionné sur le stator plan (142) ; un deuxième dispositif de déplacement (144) positionné sur le stator plan (142), sachant que le premier et le deuxième dispositif de déplacement (144) sont configurés pour se déplacer latéralement et longitudinalement sur le stator plan (142) dans un plan horizontal indépendamment l'un de l'autre;
un premier support de substrat (131) couplé au premier dispositif de déplacement (144) et positionné pour recevoir un premier substrat (150) dans une première position de chargement de substrat;
un deuxième support de substrat (131) couplé au deuxième dispositif de déplacement (144) et positionné pour recevoir un deuxième substrat (150) dans une deuxième position de chargement de substrat;
une première tête de traitement (102) configurée pour traiter le premier substrat (150) positionné sur le premier support de substrat (131) lorsque le premier support de substrat (131) se trouve dans une première position de traitement de substrat; et
une deuxième tête de traitement (102) configurée pour traiter le deuxième substrat (150) positionné sur le deuxième support de substrat (131) lorsque le deuxième support de substrat (131) se trouve dans une deuxième position de traitement de substrat;
un premier système d'inspection (200) configuré pour capturer des données concernant la position et l'orientation du premier substrat (150) disposé sur le premier support de substrat (131) lorsque le premier support de substrat (131) se trouve dans la première position de chargement de substrat; et
un deuxième système d'inspection (200) configuré pour capturer des données concernant la position et l'orientation du deuxième substrat (150) disposé sur le deuxième support de substrat (131) lorsque le deuxième support de substrat (131) se trouve dans la deuxième position de chargement de substrat;
sachant que l'appareil est configuré pour déplacer le premier support de substrat de la première position de chargement de substrat à la première position de traitement de substrat au moins en partie sur la base des données capturées par le premier système d'inspection via le stator plan et le premier dispositif de déplacement, et sachant que l'appareil est configuré pour déplacer le deuxième support de substrat de la deuxième position de chargement de substrat à la deuxième position de traitement de substrat au moins en partie sur la base des données capturées par le deuxième système d'inspection via le stator plan et le deuxième dispositif de déplacement,
et sachant que la première tête de traitement est configurée pour déposer une couche texturée sur le premier substrat positionné sur le premier support de substrat lorsque le premier support de substrat se trouve dans la première position de traitement de substrat, et sachant que la deuxième tête de traitement est configurée pour déposer une couche texturée sur le deuxième substrat positionné sur le deuxième support de substrat lorsque le deuxième support de substrat se trouve dans la deuxième position de traitement de substrat.

7. L'appareil de la revendication 6, sachant que l'appareil comprend en outre :
un troisième dispositif de déplacement (144) positionné sur le stator plan (142);
un quatrième dispositif de déplacement (144) positionné sur le stator plan (142), sachant que le premier, le deuxième, le troisième, et le quatrième dispositif de déplacement (144) sont configurés pour se déplacer latéralement et longitudinalement sur le stator plan (142) dans un plan horizontal indépendamment les uns des autres;
un troisième support de substrat (131) couplé au troisième dispositif de déplacement (144) et positionnable pour recevoir un substrat (150) dans la première position de chargement de substrat; et
un quatrième support de substrat (131) couplé au quatrième dispositif de déplacement (144) et positionnable pour recevoir un substrat (150) dans la deuxième position de chargement de substrat.

8. L'appareil de la revendication 7, sachant que la première tête de traitement (102) est configurée pour déposer une couche texturée sur un substrat (150) positionné sur le troisième support de substrat (131) lorsque le troisième support de substrat (131) se trouve dans une troisième position de traitement de substrat, et sachant que la deuxième tête de traitement (102) est configurée pour déposer une couche texturée sur un substrat (150) positionné sur le quatrième support de substrat (131) lorsque le quatrième support de substrat (131) se trouve dans une quatrième position de traitement de substrat.

9. L'appareil de la revendication 8, sachant que le premier système d'inspection (200) est en outre configuré pour capturer des données concernant la position et l'orientation d'un substrat (150) disposé sur le troisième support de substrat (131) lorsque le troisième support de substrat (131) se trouve dans la première position de chargement de substrat, et sachant que le deuxième système d'inspection (200) est en outre configuré pour capturer des données concernant la position et l'orientation d'un substrat (150) disposé sur le quatrième support de substrat (131) lorsque le quatrième support de substrat (131) se trouve dans la deuxième position de chargement de substrat.

10. L'appareil de la revendication 9, sachant que l'appareil est configuré pour déplacer le troisième support de substrat (131) de la première position de chargement de substrat à la troisième position de traitement de substrat au moins en partie sur la base des données capturées par le premier système d'inspection (200) via le stator plan (142) et le troisième dispositif de déplacement (144), et sachant que l'appareil est configuré pour déplacer le quatrième support de substrat (131) de la deuxième position de chargement de substrat à la quatrième position de traitement de substrat au moins en partie sur la base des données capturées par le deuxième système d'inspection (200) via le stator plan (142) et le quatrième dispositif de déplacement (144).

11. L'appareil de la revendication 10, sachant que la première tête de traitement (102) comprend un ou plusieurs actionneurs (105, 805) configurés pour positionner angulairement des composants dans la première tête de traitement (102) sur la base de données capturées par le premier système d'inspection (200), et sachant que la deuxième tête de traitement (102) comprend un ou plusieurs actionneurs (105, 805) configurés pour positionner angulairement des composants dans la deuxième tête de traitement (102) sur la base de données capturées par le deuxième système d'inspection (200).

12. L'appareil de la revendication 11, sachant que chacun du premier et du troisième support de substrat (131) comprend en outre un actionneur configuré pour régler angulairement le premier ou le troisième support de substrat (131) sur la base de données capturées par le premier système d'inspection (200), et sachant que chacun du deuxième et du quatrième support de substrat (131) comprend en outre un actionneur configuré pour régler angulairement le deuxième ou le quatrième support de substrat (131) sur la base de données capturées par le deuxième système d'inspection (200).

13. Procédé destiné au traitement d'un substrat (150), comprenant :
le fait d'orienter un premier support de substrat (131) dans une première position de chargement de substrat via un stator plan (142) et un premier dispositif de déplacement (144) fixé au premier support de substrat (131);
le fait d'orienter un deuxième support de substrat (131) dans une deuxième position de chargement de substrat via le stator plan (142) et un deuxième dispositif de déplacement (144) fixé au deuxième support de substrat (131);
la réception d'un premier substrat (150) sur le premier support de substrat (131);
la capture de données via un premier système d'inspection (200) concernant la position et l'orientation du premier substrat (150) sur le premier support de substrat (131);
la réception d'un deuxième substrat (150) sur le deuxième support de substrat (131);
la capture de données via un deuxième système d'inspection (200) concernant la position et l'orientation du deuxième substrat (150) sur le deuxième support de substrat (131);
le déplacement du premier support de substrat (131) de la première position de chargement de substrat à une première position de traitement de substrat au moins en partie sur la base des données capturées par le premier système d'inspection (200) via le stator plan (142) et le premier dispositif de déplacement (144);
le fait d'orienter angulairement le premier support de substrat (131) via un actionneur couplé au premier support de substrat (131) avant de traiter le premier substrat;
le traitement du premier substrat (150) via une première tête de traitement (102), sachant que la première tête de traitement est configurée pour déposer une couche texturée sur le premier substrat positionné sur le premier support de substrat lorsque le premier support de substrat se trouve dans la première position de traitement de substrat;
le déplacement du deuxième support de substrat (131) de la deuxième position de chargement de substrat à une deuxième position de traitement de substrat au moins en partie sur la base des données capturées par le premier système d'inspection (200) via le stator plan (142) et le deuxième dispositif de déplacement (144);
le fait d'orienter angulairement le deuxième support de substrat (131) via un actionneur couplé au deuxième support de substrat (131) avant de traiter le deuxième substrat; et
le traitement du deuxième substrat (150) via une deuxième tête de traitement (102), sachant que la deuxième tête de traitement est configurée pour déposer une couche texturée sur le deuxième substrat positionné sur le deuxième support de substrat lorsque le deuxième support de substrat se trouve dans la deuxième position de traitement de substrat.

14. Le procédé de la revendication 13, comprenant en outre:
le fait d'orienter angulairement des composants dans la première tête de traitement (102) sur la base de données capturées par le premier système d'inspection (200) avant de traiter le premier substrat (150); et
le fait d'orienter angulairement des composants dans la deuxième tête de traitement (102) sur la base de données capturées par le deuxième système d'inspection (200) avant de traiter le deuxième substrat (150).
